# EUROPEAN PATENT APPLICATION

(11) **EP 4 394 093 A1**
(43) Date of publication of application: **03.07.2024**
(21) Application number: 22861137.2
(22) Date of filing: 09.08.2022
(51) Int. Cl.: C30B 29/38, C30B 25/02, H01L 21/205

(54) **NITRIDE SEMICONDUCTOR SUBSTRATE AND METHOD FOR PRODUCING SAME**

(30) Priority: 26.08.2021 JP 2021138308
(71) Applicant: Shin-Etsu Handotai Co., Ltd., Tokyo 100-0004 (JP)
(72) Inventor: HAGIMOTO, Kazunori, Annaka-shi, Gunma 379-0196 (JP)
(74) Representative: Mooser, Sebastian Thomas
(86) International application number: PCT/JP2022/030400
(87) International publication number: WO 2023/026847

(57) **Abstract**

The present invention provides a nitride semiconductor substrate in which a nitride semiconductor thin film is formed on a substrate for film formation made of single-crystal silicon, in which a silicon nitride film is formed on an peripheral portion of the substrate for film formation, an AlN film is formed on the substrate for film formation and on the silicon nitride film, and the nitride semiconductor thin film is formed on the AlN film. This provides: a nitride semiconductor substrate without a reaction mark or a polycrystal growth portion on an edge portion when an AlN layer is epitaxially grown on a silicon substrate, and a GaN or AlGaN layers are epitaxially grown on top of that; and a method for manufacturing the nitride semiconductor substrate.

## Description

### TECHNICAL FIELD

The present invention relates to a nitride semiconductor substrate and a method for manufacturing a nitride semiconductor substrate.

### BACKGROUND ART

Nitride semiconductors, including GaN and AlN, can be used for producing high electron mobility transistors (HEMT: High Electron Mobility Transistor) and electronic devices with a high breakdown voltage that use two-dimensional electron gas.

It is difficult to produce a nitride wafer with these nitride semiconductor grown on a substrate. Thus, a sapphire substrate or a SiC substrate is used as the substrate. However, in order to achieve larger diameter and cost reduction of the substrate, epitaxial growth by vapor phase growth on a silicon substrate is employed (Patent Document 1). When an epitaxially grown film is formed by vapor phase growth on a silicon substrate, a substrate with a larger diameter can be used compared to the use of the sapphire substrate or the SiC substrate. Therefore, the productivity of devices is high, and there is an advantage in heat dissipation properties.

When an AlN buffer layer, a buffer layer, and a GaN-HEMT structure is epitaxially grown on the silicon substrate, some part in the AlN buffer layer is not formed neatly near the edge. When a GaN layer or an AlGaN layer is laminated thereon, in the part where the AlN film is not formed, Ga in a raw material TMG reacts with Si to generate reaction marks. This reaction mark becomes a source of particle generation during a process. In addition, even if a SiO₂ protective film is applied to prevent the generation of reaction marks, polycrystals grow on the protective film, and the residue of a chemical solution or the like remains during the process, causing failures. Consequently, it is necessary to eliminate the polycrystal growth part on a surface near the edge.

### CITATION LIST

### PATENT LITERATURE

Patent Document 1: JP 2012-36030 A

### SUMMARY OF INVENTION

### TECHNICAL PROBLEM

The present invention has been made in view of the above-described problem. An object of the present invention is to provide a nitride semiconductor substrate without a reaction mark or a polycrystal growth portion on an edge portion when an AlN layer is epitaxially grown on a silicon substrate, and a nitride semiconductor thin film is epitaxially grown on top of that, and a method for manufacturing the nitride semiconductor substrate.

### SOLUTION TO PROBLEM

To achieve the object, the present invention provides a nitride semiconductor substrate in which a nitride semiconductor thin film is formed on a substrate for film formation made of single-crystal silicon, wherein
a silicon nitride film is formed on a peripheral portion of the substrate for film formation; an AlN film is formed on the substrate for film formation and on the silicon nitride film; and the nitride semiconductor thin film is formed on the AlN film.

In this way, when the silicon nitride film is formed on the peripheral portion of the substrate for film formation made of single-crystal silicon, the generation of reaction mark is suppressed; thus, particles are not generated due to the reaction mark during a device process and adhesion of particles to the nitride semiconductor substrate is suppressed.

In addition, the nitride semiconductor thin film on the silicon nitride film is preferably a single crystal.

When the nitride semiconductor substrate has a single-crystallized nitride semiconductor thin film on the silicon nitride film, polycrystalline growth is prevented. Consequently, the residue of a chemical solution or the like does not remain during the process and does not cause a failure.

Moreover, the present invention provides a method for manufacturing a nitride semiconductor substrate, the method comprising the steps of:
(1) forming a silicon nitride film on a peripheral portion of a substrate for film formation made of single-crystal silicon;
(2) growing an AlN film on the substrate for film formation and on the silicon nitride film on the peripheral portion; and
(3) growing a GaN film, an AlGaN film, or both on the AlN film.

With this manufacturing method, the nitride semiconductor substrate, without a reaction mark or a polycrystal growth portion on an edge portion, can be manufactured relatively easily and reliably.

### ADVANTAGEOUS EFFECTS OF INVENTION

As described above, the present invention can provide a nitride semiconductor substrate and manufacturing method thereof without the reaction mark or polycrystalline growth part on the edge portion when a AlN layer is epitaxially grown on a silicon substrate and a nitride semiconductor thin film, especially a GaN or AlGaN layer, is epitaxially grown further on it.

### BRIEF DESCRIPTION OF DRAWINGS

FIG. 1 is a schematic view illustrating an example of a nitride semiconductor substrate according to the present invention.
FIG. 2 is a schematic view illustrating an example of a method for manufacturing a nitride semiconductor substrate according to the present invention.
FIG. 3 is a photograph showing a part near an edge and an edge part of a nitride semiconductor substrate manufactured in Example.
FIG. 4 is a graph showing the film thickness of the epitaxial layer measured at the edge and from the edge surface to the center in a nitride semiconductor substrate manufactured in Example.
FIG. 5 is a photograph showing a part near an edge and an edge part of a nitride semiconductor substrate manufactured in Comparative Example 1.
FIG. 6 is a cross-sectional photograph of a part near an edge and an edge part of a nitride semiconductor substrate manufactured in Comparative Example 2.
FIG. 7 is an enlarged photograph showing the polycrystal part in FIG. 6.

### DESCRIPTION OF EMBODIMENTS

As described above, the development of a nitride semiconductor substrate is desired in which no reaction mark is generated on the edge portion when a nitride semiconductor composed of an AlN buffer layer, a buffer layer, and a GaN-HEMT structure is grown epitaxially on a silicon substrate.

The present inventor has earnestly studied and found out that a silicon nitride film formed on the peripheral portion of a substrate for film formation made of single-crystal silicon can prevent the generation of a reaction mark, and that a polycrystal does not grow on the film, unlike a silicon oxide film. This finding has led to the completion of the present invention.

That is, the present invention is a nitride semiconductor substrate in which a nitride semiconductor thin film is formed on a substrate for film formation made of single-crystal silicon, wherein
a silicon nitride film is formed on a peripheral portion of the substrate for film formation; an AlN film is formed on the substrate for film formation and on the silicon nitride film; and the nitride semiconductor thin film is formed on the AlN film.

Furthermore, the present invention is a method for manufacturing a nitride semiconductor substrate, the method comprising the steps of:
(1) forming a silicon nitride film on a peripheral portion of a substrate for film formation made of single-crystal silicon;
(2) growing an AlN film on the substrate for film formation and on the silicon nitride film on the peripheral portion; and
(3) growing a GaN film, an AlGaN film, or both on the AlN film.

Hereinafter, the present invention will be described in detail. However, the present invention is not limited thereto.

### [Nitride semiconductor substrate]

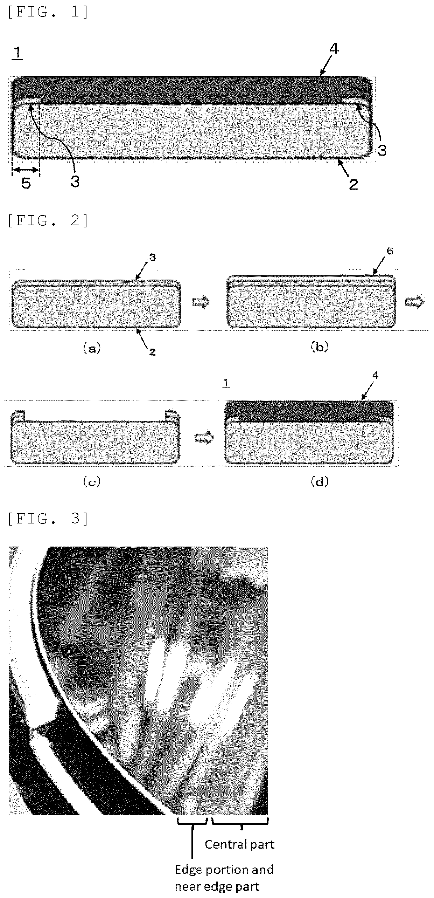

FIG. 1 shows a schematic view of an example of a nitride semiconductor substrate according to the present invention. The inventive nitride semiconductor substrate 1 has a silicon nitride film 3 formed on a peripheral portion 5 of a substrate 2 for film formation made of single-crystal silicon; moreover, an epitaxial layer 4 formed on the center part of the substrate 2 for film formation, and on the silicon nitride film 3 on the peripheral portion 5. The epitaxial layer 4 includes an AlN film (buffer layer) formed on the center part of the substrate 2 for film formation and on the silicon nitride film 3 on the peripheral portion 5 and a nitride semiconductor thin film formed on the AlN film. The nitride semiconductor thin film is not particularly limited but can be a GaN film, an AlGaN film, or both, for example.

At this point, the peripheral portion is, for example, an edge portion (the upper surface of the edge portion) and a region near the edge portion. The edge portion may be a chamfered surface.

The film thickness of the silicon nitride film 3 is not particularly limited, but, for example, can be 0.2 to 20 nm, preferably 1 to 4 nm, particularly 2 nm. The area of the peripheral portion 5 where the silicon nitride film 3 is formed is not particularly limited, but, for example, can be the edge portion and the portion near the edge of 0.2 to 20 mm, preferably 0.5 to 10 mm, more preferably 1 to 5 mm, and particularly 2.5 mm. Moreover, the thickness of the epitaxial layer 4 is not particularly limited, but, for example, can be 0.1 to 20 um, preferably 0.5 to 10 µm, more preferably 1 to 5 µm, particularly about 2.7 µm.

The substrate 2 for film formation made of single-crystal silicon is not particularly limited, but can be a CZ single-crystal silicon or an FZ single-crystal silicon and has no particular restriction on the presence or absence, type, and concentration of a dopant.

In the inventive nitride semiconductor substrate, since the silicon nitride film is formed on the peripheral portion of the substrate for film formation made of single-crystal silicon, the AlN film (buffer layer) is formed on the silicon nitride film on the peripheral portion of the growth substrate. Consequently, the AlN film (buffer layer) is well formed on the peripheral portion of the growth substrate; thus, when the GaN film or the AlGaN film is formed on the AlN film as the nitride semiconductor thin film, reaction marks cannot be generated by the reaction between Si in the growth substrate and Ga in the source gas. Moreover, by using the silicon nitride film as a film for coating the peripheral portion, the nitride semiconductor thin film formed thereon becomes a single crystal.

### [Method for manufacturing nitride semiconductor substrate]

The inventive nitride semiconductor substrate can be manufactured by an inventive method for manufacturing the nitride semiconductor substrate, as described below, for example. Hereinafter, referring to FIG. 2, the flow of the inventive method for manufacturing a nitride semiconductor substrate is described.

### <Step (1)>

To begin with, a silicon nitride film is formed on the peripheral portion of a substrate for film formation made of single-crystal silicon (Step (1)).

Firstly, as shown in FIG. 2(a), a substrate 2 for film formation (silicon substrate) made of single-crystal silicon is placed into an RTA (Rapid Thermal Annealing) furnace and heat-treated in an ammonia atmosphere diluted with argon, for example, at 1175°C for 10 seconds or in a nitrogen atmosphere, for example, at 1200°C for 10 seconds to form a silicon nitride film 3 having a thickness of such as 2 nm on the surface of the substrate 2 for film formation.

Then, as shown in FIG. 2(b), a resist 6 is applied on the silicon nitride film 3.

Then, as shown in FIG. 2(c), exposure and development are performed using the resist near the edge (for example, 2.5 mm) and on the edge portion as a protective film, and then the silicon substrate having the protective film near the edge and on the edge portion is etched, for example, for 10 seconds in a dry etching apparatus, thereby removing the silicon nitride film 3 on the part having no protective film (the center part of the substrate 2 for film formation). Next, the resist protective film on the peripheral portion is removed and the substrate is cleaned.

### <Steps (2) and (3)>

Then, a step (step (2)) in which the AlN film is grown on the substrate for film formation, and on the silicon nitride film on the peripheral portion is performed, and a step (step (3)) in which a GaN film, an AlGaN film or both is grown on the AlN film is performed.

As shown in FIG. 2(d), a nitride semiconductor (an epitaxial layer 4) including an AlN buffer layer, a buffer layer, and a GaN-HEMT layer is epitaxially grown in an MOCVD apparatus, for example, about 2.7 um. The nitride semiconductor substrate 1 manufactured in this way has a single crystal grown also on the silicon nitride film on the peripheral portion without growing a polycrystal. In addition, no reaction mark is generated at the interface between the silicon nitride film and the silicon substrate.

### EXAMPLE

Hereinafter, the present invention will be specifically described with Example and Comparative Examples. However, the present invention is not limited thereto.

### (Example)

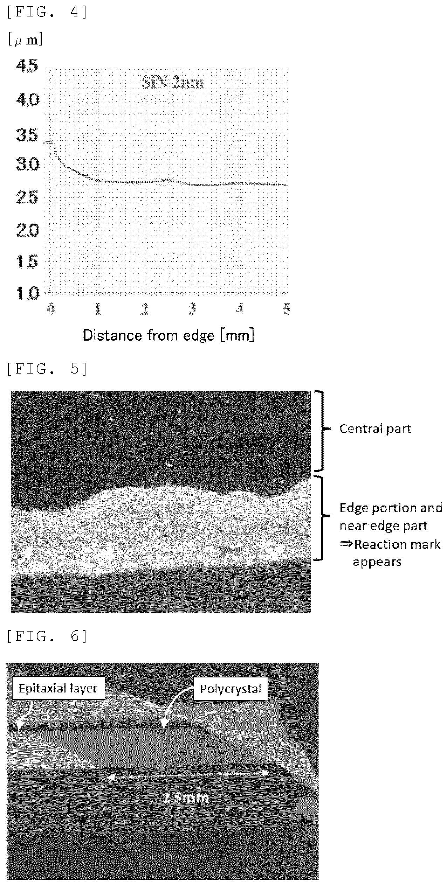

According to the flow in FIG. 2, a silicon substrate was placed in an RTA furnace, and heat-treated in an ammonia atmosphere diluted with argon at 1175°C for 10 seconds to form a silicon nitride film having a thickness of 2 nm on the entire surface. Photolithography was performed so that the resist film is left near the edge (2.5 mm) and on the edge portion. Then, etching was performed with a dry etching apparatus for 10 seconds to remove the silicon nitride film on the part having no resist film. After that, the resist film was removed and the substrate was cleaned, and a nitride semiconductor composed of an AlN buffer layer, a buffer layer, and a GaN-HEMT structure (total thickness of 2.7 µm) was epitaxially grown in an MOCVD apparatus. As a result, as shown in a photograph in FIG. 3, it has been found that the wafer had a mirror plane near the edge and on the edge portion, having no reaction mark and no grown polycrystal. Furthermore, FIG. 4 shows the film thickness [um] of epitaxial growth: the epitaxial thickness was measured every 100 um with a cross sectional SEM on the edge portion and from the surface of the edge to the center.

### (Comparative Example 1)

Except that a silicon nitride film was not formed near the edge and on the edge portion, a nitride semiconductor composed of an AlN buffer layer, a buffer layer, and a GaN-HEMT structure was epitaxially grown on a silicon substrate as in Example. As a result, as shown in FIG. 5, a reaction mark was generated near the edge and on the edge portion of the wafer.

### (Comparative Example 2)

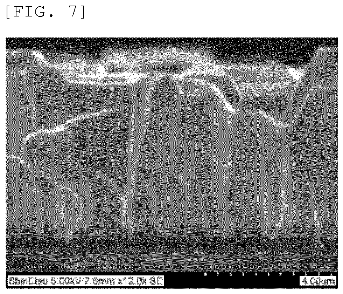

Except that a silicon oxide film was formed near the edge and on the edge portion, a nitride semiconductor composed of an AlN buffer layer, a buffer layer, and a GaN-HEMT structure was epitaxially grown as in Example. As a result, as shown in FIG. 6 and FIG. 7, although no reaction mark was observed near the edge and on the edge of the wafer, a polycrystal was grown on the silicon oxide film.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate in which a nitride semiconductor thin film is formed on a substrate for film formation made of single-crystal silicon, wherein
a silicon nitride film is formed on a peripheral portion of the substrate for film formation; an AlN film is formed on the substrate for film formation and on the silicon nitride film; and the nitride semiconductor thin film is formed on the AlN film.

2. The nitride semiconductor substrate according to claim 1, wherein
the nitride semiconductor thin film on the silicon nitride film is a single crystal.

3. A method for manufacturing a nitride semiconductor substrate, the method comprising the steps of:
(1) forming a silicon nitride film on a peripheral portion of a substrate for film formation made of single-crystal silicon;
(2) growing an AlN film on the substrate for film formation and on the silicon nitride film on the peripheral portion; and
(3) growing a GaN film, an AlGaN film, or both on the AlN film.
